**Europäisches Patentamt**

**European Patent Office**

**Office européen des brevets**

(19)

(11) Numéro de publication: **0 126 678**
**A1**

# DEMANDE DE BREVET EUROPEEN

(21) Numéro de dépôt: **84400939.9**

(22) Date de dépôt: **09.05.84**

(51) Int. Cl.³: **H 04 N 5/24,** G 01 R 13/40

(30) Priorité: **11.05.83 FR 8307907**

(43) Date de publication de la demande: **28.11.84**
**Bulletin 84/48**

(84) Etats contractants désignés: **BE DE GB NL**

(71) Demandeur: **THOMSON-CSF, 173, Boulevard Haussmann, F-75379 Paris Cedex 08 (FR)**

(72) Inventeur: **Mourier, Christian, c/o THOMSON-CSF SCPI 173 bld Haussmann, F-75379 Paris Cédex 08 (FR)**

(74) Mandataire: **Turièque, Clotilde et al, THOMSON-CSF SCPI 173, Bld Haussmann, F-75379 Paris Cedex 08 (FR)**

(54) **Dispositif de commande et de visualisation pour pupitre de télécommande muni d'un vernier.**

(57) Le dispositif selon l'invention permet d'effectuer un réglage fin sur une plage dont les valeurs extrêmes sont réglables, et permet de visualiser simultanément une valeur représentative du réglage et les valeurs extrêmes de la plage, pour une utilisation commode de ces 3 possibilités de réglage.

Le dispositif comprend: un montage potentiométrique (1) accessible à l'opérateur; un multiplexeur (14) multiplexant temporellement des tensions ($V_c$, $V_l$, $V_h$) représentatives du réglage et des valeurs extrêmes de la plage; un circuit d'affichage (2) comportant un codeur analogique-numérique (21) et une suite de diodes électroluminescentes (21). La valeur de réglage est affichée par l'une des diodes ($D_c$) située entre deux diodes ($D_l$ et $D_h$) affichant les valeurs extrêmes de la plage.

Ce dispositif de commande trouve son application dans les systèmes de télécommande en position ou en vitesse d'un organe ou d'un équipement, par exemple pour télécommander le diaphragme de l'objectif d'une caméra de télévision.

1

## Dispositif de commande et de visualisation
## pour pupitre de télécommande muni d'un vernier

La présente invention se rapporte aux pupitres des systèmes de télécommande munis d'un vernier ; elle concerne un dispositif permettant de régler à distance un organe tel que le diagramme de l'objectif d'une caméra de télévision, avec une faible étendue de la plage de réglage pour augmenter la précision, les valeurs extrêmes de cette plage étant réglées préalablement, et permettant de visualiser sur un même afficheur une valeur représentative du réglage de l'organe et les deux valeurs extrêmes de la plage de réglage.

Dans le domaine de la télévision, les caméras de prise de vue se trouvent au voisinage de la, ou des scènes à téléviser, chacune de ces caméras étant servie par un "cadreur" dont la tâche est de cadrer l'image de la scène captée par la caméra et d'assurer la mise au point optique de cette image. A chaque caméra correspond un ensemble de circuits appelé "pupitre de télécommande", lequel est relativement éloigné du lieu où est située la caméra. Les pupitres de télécommande sont rassemblées auprès d'un opérateur assurant diverses tâches de surveillance et de commandes, parmi lesquelles la commande de réglage d'ouverture/fermeture du diaphragme de l'objectif de chaque caméra.

Le dispositif de commande de diaphragme est placé sur le pupitre de télécommande et il est souhaitable que l'opérateur puisse connaître sûrement et à tout instant la valeur de réglage du diaphragme de chacune des caméras en exploitation. Le pupitre de télécommande comprend également un moniteur TV sur lequel l'opérateur vérifie la luminosité de l'image captée par la caméra correspondante. Les niveaux d'éclairement des scènes télévisées peuvent varier dans de grande limites, il est alors important de centrer la plage de réglage du diaphragme ainsi que l'étendue de cette plage de réglage en fonction de l'éclairement ambiant. Une réduction de l'étendue de cette plage procure une meilleure précision de la commande.

Dans les dispositifs de commande d'ouverture/fermeture du diaphragme de l'objectif de la caméra, la valeur du réglage de du diaphragme est généralement visualisée sur un afficheur numérique, tandis que le centrage et l'étendue de la plage de réglage sont donnés par la position mécanique des moyens de commande correspondants.

Ce mode de présentation des valeurs de réglage du diaphragme de l'objectif présente l'inconvénient que leur lecture est une opération difficile du fait de leur représentation non synthétique.

Le but de l'invention est de remédier à cet inconvénient en affichant sur un même afficheur la valeur représentative du réglage et les valeurs extrêmes de la plage, et en adaptant le dispositif de commande pour fournir à l'afficheur les signaux nécessaires. Le vernier ainsi réalisé permet une utilisation aisée des trois possibilités de réglage.

Selon l'invention, un dispositif de commande et de visualisation pour un dispositif de télécommande muni d'un vernier, permettant d'effectuer un réglage fin sur une plage dont les valeurs extrêmes sont réglables et permettant de visualiser une valeur représentative du réglage et les valeurs extrêmes de la plage, est caractérisé en ce qu'il comporte :

- un dispositif de commande manuelle pouvant fournir successivement trois signaux analogiques traduisant respectivement une valeur de consigne du réglage et les deux valeurs extrêmes de la plage ;

- un dispositif d'affichage composé d'une suite d'éléments discrets parmi lesquels un seul est allumé à chaque instant, la position de cet élément étant fonction de la valeur d'un signal analogique appliqué à cet instant, à une entrée de commande ;

- des moyens de multiplexage pour multiplexer temporellement les trois signaux analogiques du dispositif de commande manuelle et constituer ainsi un signal de commande du dispositif d'affichage, et pour fournir un signal continu dont la valeur constitue une valeur de consigne pour un servomécanisme.

D'autres caractéristiques apparaîtront dans la description détaillée d'une forme de réalisation, faite en regard de dessins annexés ; sur ces dessins :

- la figure 1 est un schéma synoptique d'une première variante de réalisation du dispositif selon l'invention ;

- la figure 2 représente un chronogramme illustrant le fonctionnement d'une partie de cette variante de réalisation ;

- la figure 3 représente un diagramme qui illustre le fonctionnement d'un montage potentiométrique que comporte cette variante de réalisation ;

- la figure 4 représente le schéma synoptique d'une forme de réalisation des moyens de multiplexage du dispositif ;

- la figure 5 représente le schéma synoptique d'une seconde variante de réalisation du dispositif selon l'invention ;

- la figure 6 représente le schéma électrique d'une forme de réalisation d'un afficheur à diodes DEL ;

- la figure 7 représente le schéma synoptique d'une variante de réalisation du dispositif de commande manuelle du dispositif selon l'invention.

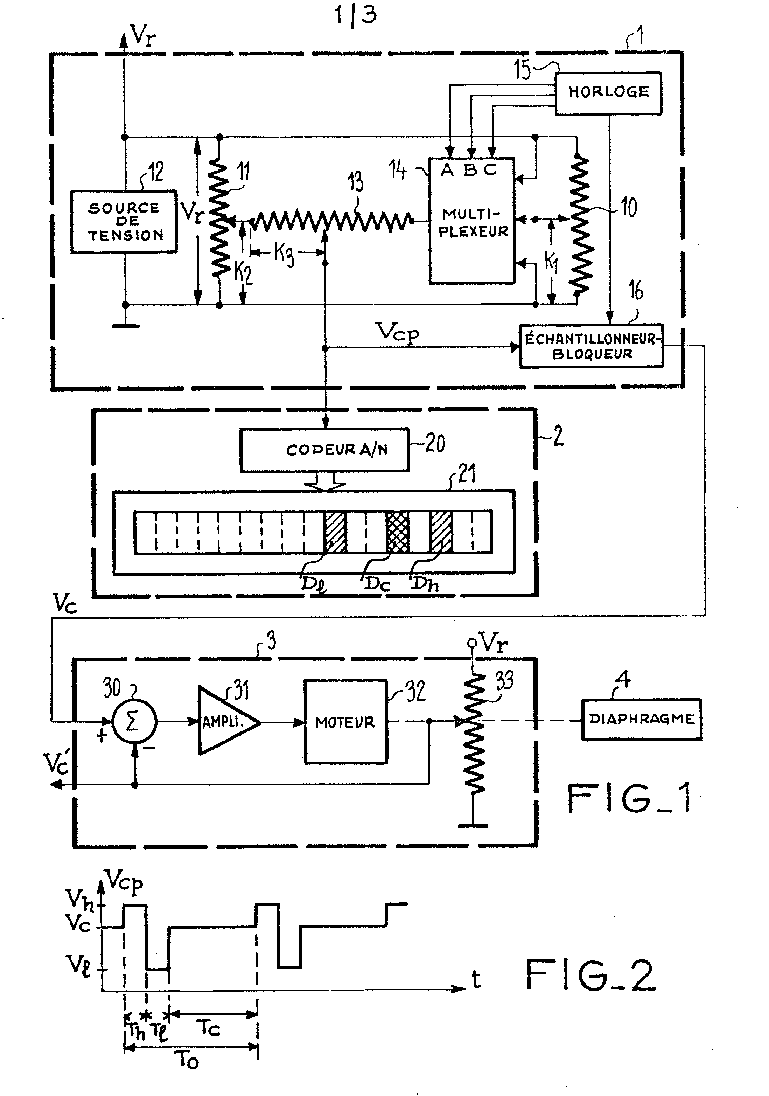

La figure 1 est un schéma synoptique d'une forme de réalisation d'un dispositif de commande et de visualisation selon l'invention. Ce dispositif comprend un dispositif de commande manuelle 1 et un circuit d'affichage 2 des grandeurs des signaux de sortie de ce dispositif 1, qui est constitué d'un montage potentiométrique. Les signaux de sortie du montage potentiométrique sont : un signal composite $V_{cp}$ et un signal $V_c$ ou signal de consigne, lequel est appliqué à l'entrée d'un servomécanisme 3 dont la fonction est de varier le réglage d'un organe mécanique tel que le diaphragme 4 de l'objectif d'une caméra de télévision.

Le montage potentiométrique comprend : un premier potentiomètre 10, ou potentiomètre de commande, qui joue le rôle de vernier et dont les extrémités sont connectées à une source 12 fournissant une tension continue de référence, $V_r$ ; un second potentiomètre 11, ou potentiomètre de centrage, dont les extrémités sont connectées à la source 12 ; et un troisième potentiomètre 13, ou potentiomètre de sensibilité, lequel est connecté entre le curseur du potentiomètre de centrage 11 et la sortie d'un multiplexeur 14. Ce multiplexeur 14 comporte trois entrées de signal qui sont connectées respectivement aux deux bornes de la source de tension 12, et au curseur du potentiomètre de commande 10.

Le multiplexeur 14 comporte des entrées de commande A, B, C qui sont connectées à un circuit d'horloge 15. La tension de sortie $V_{cp}$ du curseur du potentiomètre de sensibilité 13 est représentée à la figure 2, sous la forme d'un chronogramme. Les tensions $V_l$ et $V_h$ représentent respectivement la valeur inférieure et la valeur supérieure de la plage de réglage du diagramme, et la tension $V_c$ , représente la valeur de consigne qui fixe la valeur d'ouverture du diaphramme. La tension $V_c$ est toujours comprise entre les valeurs extrêmes $V_l$ et $V_h$. Les trois tensions continues $V_c$, $V_l$ et $V_h$ de durées respectives $T_c$, $T_l$ et $T_h$ sont multiplexés dans le temps avec une période de cycle $T_o$. Les durées $T_l$ et $T_h$ sont égales, tandis que la durée $T_c$ peut être égale ou supérieure aux durées $T_l$ et $T_h$ . Dans cet exemple : $T_c = 6.T_h = 6.T_l$ . Le signal composite $V_{cp}$ est fourni à l'entrée de signal d'un circuit échantillonneur-bloqueur 16, dont l'entrée de commande est reliée à une sortie du circuit d'horloge 15 dans le but d'extraire la valeur de consigne $V_c$ par un échantillonnage au cours de la durée $T_c$ .

L'afficheur 2 des données de réglage du dispositif 1 de commande manuelle comprend, connectés en série : un codeur analogique-numérique (A/N) 20 et un ensemble de 16 diodes émettrices de lumière (DEL) 21 régulièrement espacées et disposées en ligne. L'entrée du codeur A/N reçoit le signal composite $V_{cp}$ et fournit un signal numérique d'adressage des diodes DEL. Trois diodes DEL seulement sont allumées ; elles sont hachurées sur la figure : une première diode $D_l$ qui visualise la tension $V_l$ , une seconde diode $D_c$ qui visualise la tension $V_c$ et enfin une troisième diode $D_h$ qui visualise la tension $V_h$ . La position de chaque DEL allumée est fonction de la tension qu'elle visualise. Les DEL $D_l$ , $D_c$ , et $D_h$ sont allumées respectivement pendant les durées $T_l$ , $T_c$ et $T_h$ . La luminosité relative de la diode $D_c$ est six fois plus importante que la luminosité des diodes $D_l$ et $D_h$ afin qu'elle soit différenciée visuellement ; cet effet est obtenu en augmentant la durée $T_c$ du signal $V_c$ , par rapport à $T_l$ et $T_h$ . Le multiplexeur 14 et le circuit d'horloge 15 sont décrits plus loin.

Le bloc servomécanisme 3 est d'un type classique comprenant : un circuit de sommation 30, un amplificateur d'erreur 31, et un organe moteur 32 qui est couplé mécaniquement, d'une part, à un potentiomètre de recopie 33 alimenté par la tension de référence $V_r$, et d'autre part, au diaphragme 4 de l'objectif de la caméra de télévision. Le signal de retour $V'_c$ du servomécanisme est rendu disponible à l'extérieur en vue de son utilisation éventuelle dans le circuit d'affichage 2 comme il sera décrit ultérieurement.

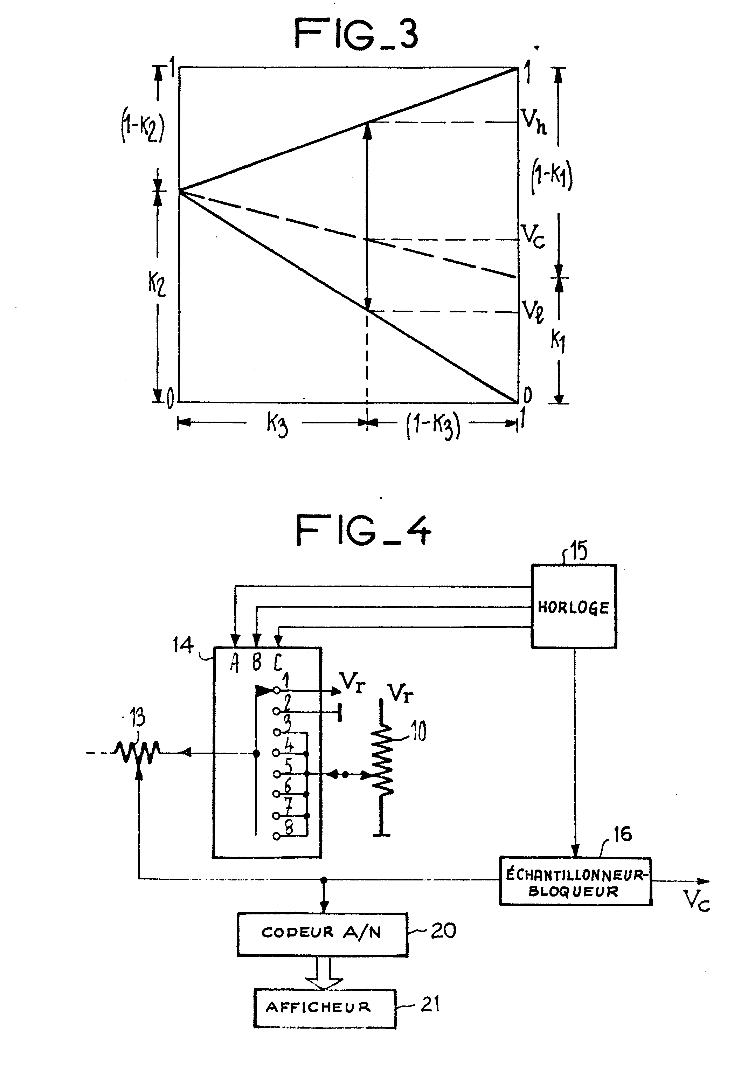

La figure 3 est un diagramme qui illustre le fonctionnement du montage potentiométrique du dispositif 1 de commande manuelle. Sur ce diagramme, la grandeur $K_2$ représente la position du curseur du potentiomètre de centrage 11 ; $K_3$ la position du curseur du potentiomètre de sensibilité 13 ; et $K_1$ la position du curseur du potentiomètre de commande 10. Le potentiomètre de centrage 11 permet de centrer la plage de réglage du diaphragme 4, le potentiomètre de sensibilité 13 permet de régler l'étendue $V_h - V_1$ de cette plage ; et le potentiomètre de commande 10 permet de régler la valeur $V_c$ dans cette plage. De plus, sur ce diagramme on a supposé arbitrairement que la valeur de la tension de référence $V_r$ est égale à l'unité.

La figure 4 représente le schéma synoptique d'une forme de réalisation du multiplexeur 14 de la figure 1, qui permet de renforcer la luminosité de la diode $D_c$ par rapport à la luminosité des diodes $D_1$ et $D_h$. Il est constitué d'un circuit multiplexeur intégré possèdant une sortie et 8 entrées de signal, référencées 1 à 8 ; la première entrée est connectée à la tension de référence $V_r$, la seconde entrée est connectée au potentiel de la masse, et les entrées 3 à 8 sont toutes connectées au curseur du potentiomètre de commande 10. Les entrées de commande A, B et C du multiplexeur sont connectées au circuit d'horloge 15. Selon cette forme de réalisation du multiplexeur 14, le signal de consigne $V_c$ a une durée $T_c$ égale à 6 fois la durée $T_h$ ou $T_b$. Ce circuit de multiplexage peut être réalisé directement par un multiplexeur intégré, du modèle 4051B disponible commercialement.

Le circuit d'horloge 15 est constitué d'un oscillateur, d'un décodeur et d'un compteur binaire. L'oscillateur a une fréquence élevée pour que le multiplexage de l'affichage ne soit pas perceptible visuellement. Le compteur binaire a 3 étages commandés par cet oscillateur pour fournir une suite de mots binaires de 3 bits, valant 0 à 7, et de durées identiques.

Le décodeur peut être constitué par une porte OU à deux entrées, ces dernières étant reliées aux deux sorties de poids le plus fort du compteur, pour fournir un bit de valeur 1 pendant la durée où le contenu du compteur est égal à 3, ... , 7. Ce signal permet d'échantillonner la tension $V_{cp}$ pendant le palier de la valeur $V_c$ au moyen de l'échantillonneur-bloqueur 16 pour fournir une tension $V_c$ constante au servomécanisme 3.

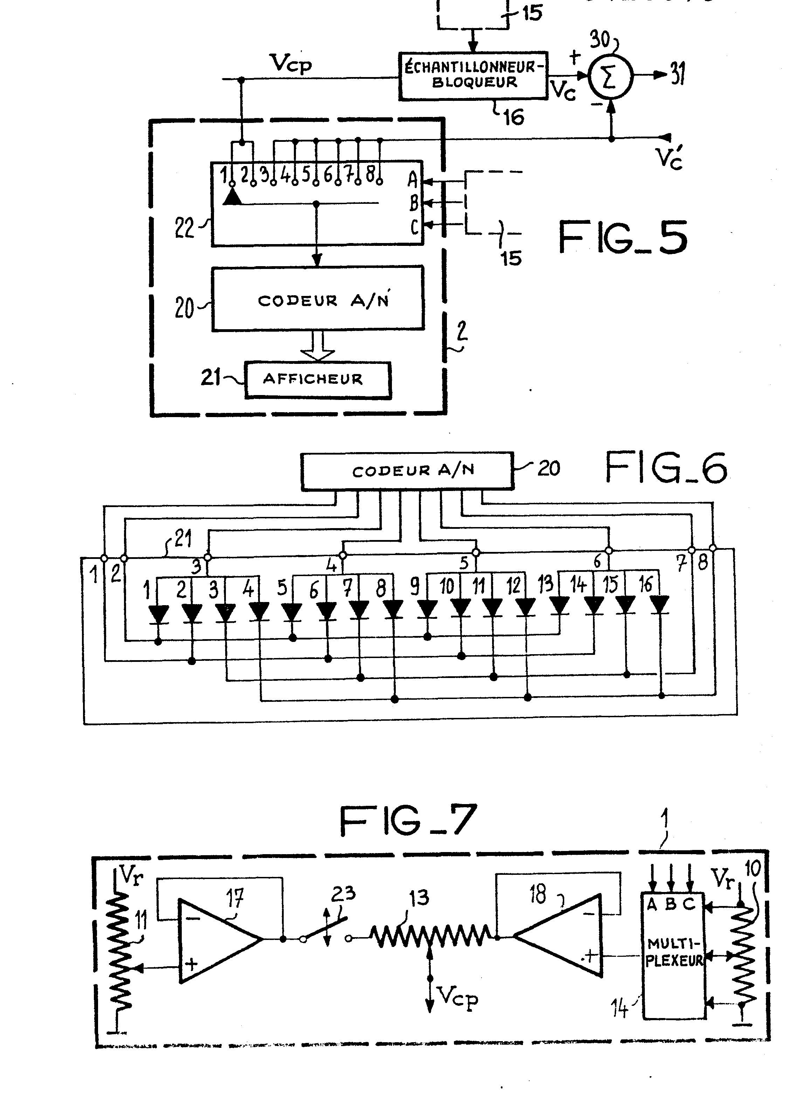

La figure 5 représente le schéma synoptique d'une partie d'une seconde variante de réalisation du dispositif selon l'invention, qui comporte en plus des éléments de la première variante un second multiplexeur 22. Cette seconde variante permet d'afficher la valeur effective de réglage, au lieu de la valeur de consigne. En régime établi la valeur effective de réglage est identique à la valeur de consigne, mais ce n'est pas le cas pendant les transitoires. Dans certaines applications, il peut être utile de visualiser plutôt la valeur du réglage effectif que la valeur de consigne à cause des transitoires. Le second multiplexeur 22 est inséré entre la sortie du montage potentiométrique du dispositif 1 fournissant la tension composite $V_{cp}$ et le codeur analogique-numérique 20.

Le multiplexeur 22 est réalisé au moyen d'un multiplexeur intégré 4051. Il comporte 8 entrées référencées de 1 à 8, trois entrées de commande A, B, C, et une sortie. Les entrées 1 et 2 reçoivent la tension composite $V_{cp}$, les entrées 3 à 8 reçoivent toutes la tension $V'_c$ fournie en retour par le servomécanisme 3, et les entrées de commande A, B, C sont reliées en parallèle avec les entrées de commande A, B, C du multiplexeur 14. La sortie du multiplexeur 22 est reliée à l'entrée du codeur A/N 20.

Pendant la durée des intervalles $T_h$ et $T_l$ le multiplexeur 22 transmet la tension composite $V_{cp}$ pour afficher les valeurs extrêmes $V_l$ et $V_h$ délimitant la plage de réglage. Pendant la durée de l'intervalle $T_c$ le multiplexeur 22 transmet la tension en retour $V'_c$ pour afficher la valeur effective du réglage $V'_c$, au lieu de la valeur de consigne $V_c$.

La figure 6 est un schéma électrique d'une forme de réalisation de l'afficheur 21 à diodes DEL. Dans ce mode de réalisation l'afficheur 21 comporte 16 diodes DEL alignées, mais interconnectées sous la forme d'une matrice 4 x 4. Elles sont adressées par 8 fils référencés 1 à 8 qui sont connectés à la sortie du codeur A/N 20. Le réseau des diodes DEL 1 à 16 peut être réalisé directement à l'aide de deux circuits intégrés RBG 1000 comportant chacun 8 diodes DEL, tandis que le codeur A/N 20 peut être réalisé par un circuit intégré 2160 UAA 170.

La figure 7 est un schéma électrique d'une variante de réalisation du montage potentiomètrique du dispositif 1 de commande manuelle, permettant de s'affranchir des impédances des potentiomètres 10, 11 et 13. A cet effet, un premier amplificateur opérationnel 17 constituant un amplificateur à gain unitaire, est disposé entre le curseur du potentiomètre de centrage 11 et l'extrémité correspondante du potentiomètre de sensibilité 13, et un second amplificateur opérationnel 18 constituant un autre amplificateur à gain unitaire, est connecté entre la sortie du circuit de multiplexage 14 et l'autre extrémité du potentiomètre de sensibilité 13. Il faut noter, toutefois que ces deux amplificateurs 17 et 18 sont des éléments optionnels qui ne sont pas rigoureusement nécessaires au fonctionnement du dispositif de commande, mais dont le but est uniquement d'assurer un découplage électrique des potentiomètres.

Il est possible aussi d'insérer un interrupteur 23, entre la sortie de l'amplificateur 17 et le potentiomètre 13, pour supprimer instantanément l'effet de vernier. Il est possible alors de commander le réglage du diaphragme sur la plage de fonctionnement la plus grande possible, au moyen du potentiomètre 10.

L'invention n'est pas limitée aux formes de réalisation décrites ici à titre purement illustratif. Notamment, l'afficheur 21 peut être d'un type différent, par exemple à cristaux liquides ou à éléments électroluminescents. Le nombre d'éléments de l'afficheur peut être varié. De même les formes de réalisation des circuits de multiplexage n'ont été données qu'à titre indicatif et d'autres composants peuvent être utilisés.

L'invention n'est pas limitée dans ses applications à la commande d'ouverture/fermeture du diaphragme d'une caméra de télévison, cette application étant donnée uniquement dans un but illustratif. L'invention trouve son application générale, dans les systèmes de télécommande d'un équipement ou des organes de cet équipement. Le spécialiste pourra également comprendre que l'invention n'est pas uniquement limitée à la commande de position d'un organe, mais englobe également les systèmes de télécommande en vitesse d'un organe.

# REVENDICATIONS

1. Dispositif de commande et de visualisation pour un pupitre de télécommande muni d'un vernier, permettant d'effectuer un réglage fin sur une plage dont les valeurs extrêmes sont réglables et permettant de visualiser une valeur représentative du réglage et les valeurs extrêmes de la plage ; caractérisé en ce qu'il comporte :

- un dispositif de commande manuelle (1) pouvant fournir successivement trois signaux analogiques ($V_c$, $V_1$, $V_h$) traduisant respectivement une valeur de consigne du réglage et les deux valeurs extrêmes de la plage ;

- un dispositif d'affichage (2) composé d'une suite d'éléments discrets parmi lesquels un seul est allumé à chaque instant, la position de cet élément étant fonction de la valeur d'un signal analogique appliqué, à cet instant, à une entrée de commande ;

- des moyens de multiplexage (14, 15, 16, 20) pour multiplexer temporellement les trois signaux analogiques ($V_c$, $V_1$, $V_h$) du dispositif de commande manuelle (1) et constituer ainsi un signal de commande du dispositif d'affichage (2), et pour fournir un signal continu dont la valeur ($V_c$) constitue une valeur de consigne pour un servomécanisme (3).

2. Dispositif selon la revendication 1, caractérisé en ce que :

- le dispositif de commande manuelle (1) comporte un premier potentiomètre (10) pour fournir une tension ($V_c$) correspondant à la valeur de consigne de réglage, le déplacement complet du curseur correspondant à toute la plage du réglage ;

et en ce que les moyens de multiplexage comportent :

- un premier multiplexeur (14) ayant trois entrées reliées respectivement à trois bornes du premier potentiomètre (10) pour prélever successivement trois signaux correspondant respectivement à la valeur de consigne du réglage et aux deux valeurs extrêmes de la plage, ayant une sortie couplée à l'entrée de commande du dispositif d'affichage (2) ;

- un échantillonneur (16) ayant une entrée couplée à la sortie du multiplexeur (14), et une sortie, pour fournir le signal continu dont la valeur ($V_c$) constitue la valeur de consigne ;

- un circuit d'horloge (15) pour commander le multiplexeur (14) et de l'échantillonneur-bloqueur (16).

3. Dispositif selon la revendication 2, caractérisé en ce que les moyens de multiplexage (14, 15) réalisent un multiplexage temporel où la durée ($T_c$) de transmission du signal ($V_c$) traduisant la valeur de consigne du réglage est beaucoup plus longue que la durée de transmission ($T_l$, $T_h$) de chacun des signaux ($V_l$, $V_h$) traduisant les valeurs extrêmes de la plage, afin d'afficher ces deux dernières valeurs avec moins de luminosité que la valeur de consigne du réglage.

4. Dispositif selon la revendication 2, où la valeur représentative du réglage à visualiser est la valeur ($V'_c$) d'un signal de retour fourni par le servomécanisme (3), caractérisé en ce que les moyens de multiplexage comportent en outre un second multiplexeur (22) ayant une première entrée couplée à la sortie du premier multiplexeur (14) pour recevoir les trois signaux analogiques ($V_c$, $V_l$, $V_h$) multiplexés temporellement ; ayant une seconde entrée recevant le signal de retour ($V'_c$) fourni par le servomécanisme (3) ; ayant une entrée de commande reliée au circuit d'horloge (15) ; et ayant une sortie reliée à l'entrée de commande de l'afficheur (2) pour lui fournir un signal où sont multiplexés temporellement les deux signaux ($V_l$, $V_h$) traduisant les valeurs extrêmes de la plage et le signal de retour ($V'_c$).

5. Dispositif selon la revendication 2, caractérisé en ce que le dispositif de commande manuelle (1) comporte en outre :

- un second potentiomètre (11) pour fournir une tension correspondant au centrage de la plage ;

- un troisième potentiomètre (13), pour fournir une tension correspondant à l'étendue de la plage, l'une des deux bornes extrêmes de ce potentiomètre (13) étant couplée au curseur du second potentiomètre (11), l'autre borne extrême étant reliée à la sortie du premier multiplexeur (14) et son curseur constituant une sortie couplée à l'entrée de commande du dispositif d'affichage (2).

6. Dispositif selon la revendication 5, caractérisé en ce que le curseur du second potentiomètre (11) est couplé à une borne extrême du troisième potentiomètre (13) par un commutateur (23) permettant de donner à la plage son étendue maximale.

FIG_1

FIG_2

0126678

1/3

## FIG_3

## FIG_4

FIG_5

FIG_6

FIG_7

Office européen
des brevets

**RAPPORT DE RECHERCHE EUROPEENNE**

0126678

Numéro de la demande

EP 84 40 0939

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | FR-A-2 393 492 (RCA)<br>* Page 36, revendication 4 *<br><br>--- | 1 | H 04 N 5/24<br>G 01 R 13/40 |
| A | ELEKTRONIK, vol. 31, no. 2, 26 février 1982, Munich (DE) R. WICKLAUS:"Komfortable Leuchtpunktanzeige", page 72<br>* Colonne de gauche, lignes 7-15 *<br><br>--- | 1,3 | |
| A | FR-A-2 422 935 (DR. E. FRESENIUS CHEMISCH-PHARMAZEUTISCHE INDUSTRIE KG APPARATEBAU KG)<br>* Page 9, revendication 1 *<br><br>----- | 1 | |

**DOMAINES TECHNIQUES RECHERCHES (Int. Cl. ³)**

H 04 N 5/24
G 01 R 13/40

Le présent rapport de recherche a été établi pour toutes les revendications

| Lieu de la recherche | Date d'achèvement de la recherche | Examinateur |
|---|---|---|
| LA HAYE | 10-08-1984 | SIX G.E.E. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant

OEB Form 1503. 03.82